# EUROPÄISCHE PATENTSCHRIFT

(11) **EP 0 569 801 B1**
(45) Veröffentlichungstag und Bekanntmachung des Hinweises auf die Patenterteilung: **09.07.1997**
(21) Anmeldenummer: 93107094.0
(22) Anmeldetag: 30.04.1993
(51) Int. Cl.: H05K 1/16, H05K 3/46

(54) **Mehrlagen Leiterplatte**
Multilayer circuit board
Plaquette de circuit imprimé multi-couche

(30) Priorität: 12.05.1992 DE 4215553; 28.07.1992 DE 4224925; 23.04.1993 DE 4313389
(43) Veröffentlichungstag der Anmeldung: 18.11.1993
(73) Patentinhaber: SIEMENS AKTIENGESELLSCHAFT, 80333 München (DE)
(72) Erfinder: Koch, Georg, W-8044 Unterschleissheim (DE); Steiner, Dinorah, W-8000 München 90 (DE); Österwitz, Rolf, Dipl.-Ing., W-8021 Icking (DE); Schlitter, Hans, W-8014 Neubiberg (DE); Lennert, Adam, Dipl.-Ing., W-8000 München 71 (DE)

(56) Entgegenhaltungen:
- US-A- 4 870 746
- PATENT ABSTRACTS OF JAPAN, Bd. 17, Nr. 089 (E-1323)22. Februar 1993 & JP-A-42 83 999

## Beschreibung

Die Erfindung bezieht sich auf eine Mehrlagen-Leiterplatte (Multilayer) mit in gedruckter Technik realisierten ohmschen, induktiven und/oder kapazitiven Bauelementen wie sie im Oberbegriff von Anspruch 1 und z.B. in der US 4 870 746 beschrieben ist.

Die Multilayer-Technik ist in ihrem Aufbau sehr kompakt und daher platzsparend, also sehr vorteilhaft im Zuge der Miniaturisierung elektrischer Baugruppen. Es bleibt jedoch auch weiterhin ständiges Bestreben, das Gerätevolumen möglichst klein zu halten und optimal zu nutzen. Die Erfindung betrifft zudem eine auf einer Mehrlagen-Leiterplatte angeordnete SMD (Surface-Mounted-Device)-Baugruppe mit ohmschen Widerständen. In SMD-Technik sind hochwertige und kostengünstige Miniaturbauelemente herstellbar. Im Zuge der Miniaturisierung von SMD-Baugruppen ist es dabei auch wichtig, die konventionellen aufgelöteten SMD-Widerstände in entsprechender Weise zu verkleinern. Konventionelle SMD-Widerstände werden mit dem Bestückungsautomaten auf die Leiterplatte appliziert und anschließend wellen- oder reflowgelötet.

Der Erfindung liegt daher die Aufgabe zugrunde, für eine Anordnung der eingangs beschriebenen Art eine Lösung für einen platzsparenden Aufbau anzugeben.

Diese Aufgabe wird gemäß dem kennzeichnenden Teil von Anspruch 1.

Durch die Integration der gedruckten Bauelemente in der Innenlage von Mehrlagen-Leiterplatten ergibt sich, auch durch kleinere Leiterplatten bedingt, ein platzsparender Aufbau und zugleich der Vorteil, daß diese Teile der Anordnung gegen äußere Einflüsse geschützt sind. Die Außenfläche der Leiterplatten wird dadurch besser nutzbar für andere Bauelemente.

Vorteilhafte Ausgestaltungen und Weiterbildungen des Erfindungsgegenstandes sind in den Unteransprüchen angegeben.

Nachstehend wird die Erfindung anhand von in der Zeichnung dargestellten Ausführungsbeispielen näher erläutert. In den Figuren 1a bis 1d ist der Aufbau einer Mehrlagen-Leiterplatte in verschiedenen Phasen dargestellt, Figur 2 zeigt eine Ausführungsform eines Störschutzelementes und eines Kondensators und die Figuren 3 bis 5 zeigen verschiedene Konfigurationen der Widerstände der SMD-Baugruppe, ausgelegt für die Widerstandspaste mit einem bestimmten Ausgangswiderstand pro Flächeneinheit.

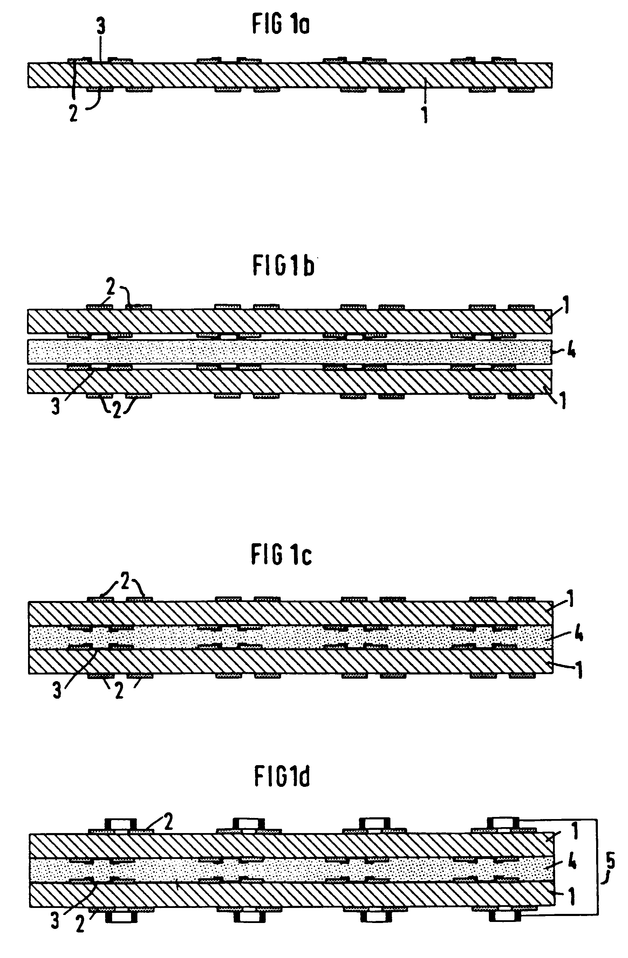

Figur 1 zeigt eine einzelne Leiterplatte 1, die beidseitig mit Leiterbahnen 2 beispielsweise aus Cu-Pad versehen ist. Auf der einen Leiterplattenseite sind zwischen jeweils zwei benachbarten Leiterbahnen Widerstandschichten aufgebracht, die sich über einen Teil der Leiterbahnbreite erstrecken. Die Widerstände bestehen aus einer aushärtbaren Widerstandspaste und sind aufgedruckt.

Nach dem Drucken und Aushärten der Widerstandspaste werden zwei entsprechend Figur 1a ausgebildete Leiterplatten mit Leiterbahnen und Widerstandsschichten mit der die gedruckten Widerstände tragenden Innenseite einander zugekehrt unter Zwischenlage einer elastischen Isolierschicht 4 zusammengefügt (siehe Figur 1b). Dieser Aufbau erfolgt mit Hilfe von Justierwerkzeugen, so daß Leiterbahnen und Anschlüsse exakt in die gewünschte Position gebracht werden.

Figur 1c zeigt eine Mehrlagen-Leiterplatte nach dem Zusammenpressen. Die elastische Isolierschicht 4 hat dabei die Funktion des Zusammenhaltens der Leiterplatten und der Isolation. Das Verpressen der Multilayer kann dabei in der Presse oder im Autoklaven, d.h. unter Vakuum erfolgen.

Figur 1d zeigt ein Multilayer im verpreßten Zustand gemäß Figur 1c, das an seinen beiden Außenseiten mit SMD's 5 (Service-Mounted-Device) bestückt ist.

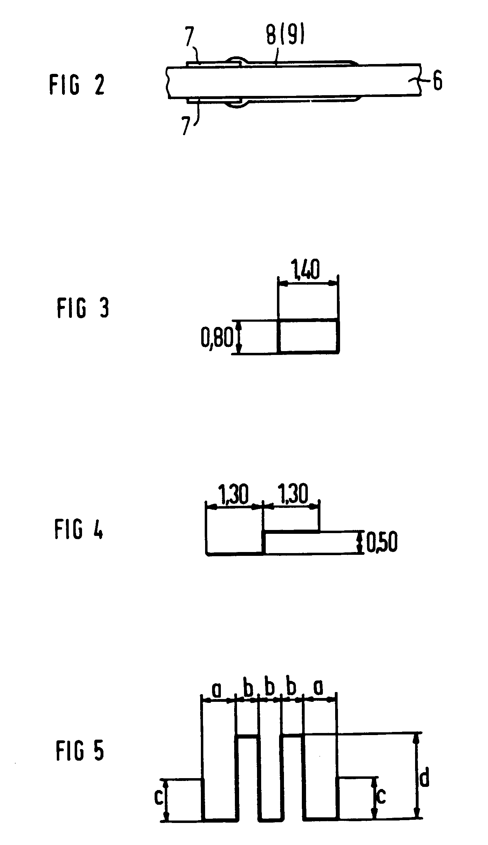

Figur 2 zeigt als weitere Möglichkeit der drucktechnischen Realisierung von Bauelementen ein Störschutzelement, das schaltungstechnisch aus der Reihenschaltung eines ohmschen Widerstandes und eines Kondensators besteht. Dabei sind auf einer Zwischenlage 6 der Dicke d aus dielektrischem Material beidseitig einander gegenüberliegend eine Leiterbahn 7 und jeweils eine sich über einen Teil der Leiterbahn und die Oberfläche der Zwischenlage 1 erstreckende Schicht 8 (Fläche F) aus hochohmiger Widerstandspaste aufgebracht. Die entsprechend ausgebildete Zwischenschicht kann mit einer Leiterplatte oder als Innenlage mit zwei außen angeordneten Leiterplatten gemäß der vorstehend beschriebenen Weise für die Widerstände nach Figur 1 zusammengefügt und verpreßt und mit SMD's bestückt werden.

Bei der Realisierung eines Kondensators, die ähnlich der des Störschutzelementes aussieht, ist auf einer Zwischenlage 6 auf beiden Seiten einander gegenüberliegend eine Leiterbahn 7 und jeweils eine sich über einen Teil der Leiterbahn und die Oberfläche der Zwischenlage 6 erstreckende Schicht 9 aus einem Leitkleber oder einer niederohmigen Widerstandspaste aufgebracht. Die Fläche F des Leitklebers bzw. der niederohmigen Widerstandspaste ist dabei variabel. Der übrige Aufbau mit Leiterplatten und MSD-Bestückung kann in der bereits beschriebenen Weise erfolgen.

Zur Herstellung von siebgedruckten Widerständen auf Leiterplattenbasismaterialien der SMD-Baugruppen werden Polymer-Widerstandspasten, beispielsweise auf Epoxy- und Phenolbasis verwendet. Die Widerstandspasten werden mittels eines Siebes oder einer Schablone mit entsprechenden Konfigurationen mit einer Siebdruckmaschine auf die Leiterplatten gedruckt und anschließend durch Wärmezufuhr ausgehärtet. Die Widerstandswerte werden durch den sogenannten Ausgangswiderstand der Widerstandspaste, dekadisch von 100 kohm bis 1 Mohm pro Flächeneinheit, und die Geometrie der gedruckten und ausgehärteten Widerstände bestimmt.

Ein wesentlicher Vorteil dieses Verfahrens ist, daß die siebgedruckten Widerstände gegenüber den konventionellen SMD-Widerständen einen geringeren Platzbedarf auf der Leiterplatte benötigen und somit eine höhere Packungsdichte einer SMD-Baugruppe zulassen. Durch die geringe Höhe (ca. 12 µm) und eine wesentlich kleinere Abmessung (L x B) können siebgedruckte Widerstände unter großflächigen Bauelementen plaziert werden, was zur zusätzlichen Reduzierung der Leiterplattengröße beiträgt. In dieser Art realisierte Widerstände ermöglichen einen sehr kostengünstigen Aufbau.

Figur 3 zeigt ein Beispiel mit einem Ausgangswiderstand von 10 kohm pro Flächeneinheit, bestehend aus einem rechteckförmigen Widerstandsbelag mit den Seitenflächen 0,80 x 1,40 mm.

Ein Beispiel für einen 100 kohm-Widerstand ist in Figur 4 dargestellt. Die Konfiguration des Widerstands besteht aus einer zweifach rechtwinklig gegensinnig abgewinkelten Leiterbahn der Bahnbreite von 0,250 mm und einer Länge von zwei zueinander versetzt in verschiedenen Ebenen parallel verlaufenden Abschnitten von 1,30 mm und einem dazwischenliegenden Verbindungsstück von 0,50 mm.

Ein 500 kohm-Widerstand ist in Figur 5 gezeigt. Dieser besteht aus einer mäanderförmig ausgebildeten Leiterbahn mit einer Bandbreite von 0,250 mm. Dabei sind vier parallel zueinander verlaufende Leiterbahnabschnitte der Länge d = 2,00 mm durch drei wechselweise in den Endbereichen angeordnete kurze Leitungsabschnitte der Länge b = 0,50 mm miteinander verbunden. An die beiden freien Enden der langen Leiterbahnabschnitte schließt sich jeweils ein Leiterbahnabschnitt der Länge ä = 0,80 mm an und an diese, parallel zu en d-langen Leiterbahnabschnitten jeweils ein Leiterbahnabschnitt der Länge c= 1,00 mm.

## Patentansprüche

1. Mehrlagen-Leiterplatte (Multilayer) mit in gedruckter Technik realisierten ohmschen, induktiven und/oder kapazitiven Bauelementen, bei der die Bauelemente schichtförmig zwischen den Leiterbahnen der einen Seite von wenigstens einseitig mit Leiterbahnen versehenen Leiterplatten mit einer dazwischen liegenden Isolierschicht aufgedruckt sind und die Leiterplatte(n) und die Isolierschicht nach dem Aushärten der Bauelemente mit der die Bauelemente tragenden Innenseite einander zugekehrt angeordnet und verpreßt sind, dadurch **gekennzeichnet,** daß die Widerstände aus einer aushärtbaren Widerstandspaste schichtförmig zwischen den Leiterbahnen und über einen Teil der Leiterbahnbreite erstreckend der einen Seite von doppelseitig mit Leiterbahnen versehenen Leiterplatten und/oder auf wenigstens einer Seite einer doppelseitig mit Leiterbahnen versehenen isolierschicht aus dielektrischem Material aufgedruckt sind und nach dem Aushärten der Widerstände mit der die Widerstände tragenden, einander zugekehrten Innenseite unter Zwischenlage einer Isolierschicht zusammengefügt und verpreßt sind.

2. Mehrlagen-Leiterplatte nach Anspruch 1, dadurch **gekennzeichnet,** daß das Verpressen in einer Presse oder im Autoklaven erfolgt.

3. Mehrlagen-Leiterplatte nach Anspruch 1 oder 2, dadurch **gekennzeichnet,** daß die Außenseiten der verpreßten Multilayer mit SMD's bestückt sind.

4. Mehrlagen-Leiterplatte nach Anspruch 3 mit einer SMD-Baugruppe mit ohmschen Widerständen, **gekennzeichnet** durch deren Realisierung als siebgedruckte Widerstände, indem eine Widerstandspaste mittels eines Siebes oder einer Schablone auf einem Leiterplattenbasismaterial aufgebracht und anschließend durch Wärmezufuhr ausgehärtet wird.

5. Mehrlagen-Leiterplatte nach Anspruch 4, **gekennzeichnet** durch die Verwendung von Polymer-Widerstandspasten.

6. Mehrlagen-Leiterplatte nach Anspruch 5, dadurch **gekennzeichnet,** daß die Widerstandspasten auf Epoxy- oder Phenolbasis aufgebaut sind.

7. Mehrlagen-Leiterplatte nach einem der Ansprüche 4 bis 6, dadurch **gekennzeichnet,** daß die Widerstandspasten mit einer Siebdruckmaschine auf die Leiterplatten gedruckt sind.

8. Mehrlagen-Leiterplatte nach einem der Ansprüche 4 bis 7, **gekennzeichnet** durch eine flächenförmige oder linienförmige Konfiguration oder gefaltete Linienführung entsprechend dem Widerstandswert/Flächeneinheit der Widerstandspaste.

9. Mehrlagen-Leiterplatte nach einem der Ansprüche 4 bis 8, **gekennzeichnet** durch die Anordnung der Widerstände unter großflächigen Bauelementen.

## Claims

1. Multilayer printed circuit board (multilayer) having resistive, inductive and/or capacitive components which are realized using printed technology, in which the components are printed on in layer form between the conductor tracks of one side of printed circuit boards provided with conductor tracks at least on one side and having an insulating layer situated in between and, after the components have been cured, the printed circuit board(s) and the insulating layer are arranged facing one another with the inner side carrying the components and are pressed, characterized in that the resistors made of a curable resistor paste are printed on in layer form between the conductor tracks, and extending over part of the conductor track width, of one side of printed circuit boards provided with conductor tracks on two sides and/or on at least one side of an insulating layer which is provided with conductor tracks on two sides and is made of dielectric material, and, after the resistors have been cured, the printed circuit boards and the insulating layer are joined together with the inner side, carrying the resistors and facing one another, with the interposition of an insulating layer and are pressed.

2. Multilayer printed circuit board according to Claim 1, characterized in that the pressing is carried out in a press or in an autoclave.

3. Multilayer printed circuit board according to Claim 1 or 2, characterized in that the outer sides of the pressed multilayers are populated with SMDs.

4. Multilayer printed circuit board according to Claim 3 having an SMD assembly with non-reactive resistors, characterized by the realization of the latter as screen-printed resistors by applying a resistor paste by means of a screen or a mask to a printed circuit board base material and subsequently curing it by supplying heat.

5. Multilayer printed circuit board according to Claim 4, characterized by the use of polymer resistor pastes.

6. Multilayer printed circuit board according to Claim 5, characterized in that the resistor pastes are based on epoxy or phenol.

7. Multilayer printed circuit board according to one of Claims 4 to 6, characterized in that the resistor pastes are printed onto the printed circuit boards using a screen printing machine.

8. Multilayer printed circuit board according to one of Claims 4 to 7, characterized by an areal or linear configuration or folded line routing in accordance with the resistance/unit area of the resistor paste.

9. Multilayer printed circuit board according to one of Claims 4 to 8, characterized by the arrangement of the resistors under large-area components.

## Revendications

1. Plaquette de circuit imprimé multicouche (multilayer) comprenant des composants ohmiques, inductifs et/ou capacitifs réalisés dans la technique du circuit imprimé, dans laquelle les composants sont imprimés sous forme de couches entre les pistes conductives de l'une des faces de plaquettes de circuit imprimé pourvues de pistes conductives sur au moins un côté et ayant une couche isolante située entre elles, et la/les plaquette/s de circuit imprimé et la couche isolante sont disposées et pressées avec leurs faces internes portant les composants tournés les uns vers les autres, après le durcissement des composants, caractérisée en ce que les résistances faites d'une pâte de résistance durcissable sont imprimées, sous forme de couches, entre les pistes conductives - et en s'étendant sur une partie de la largeur des pistes conductives - d'une des faces de plaquettes de circuit imprimé pourvues de pistes conductives sur les deux côtés et/ou sur au moins une face d'une couche isolante faite d'un matériau diélectrique pourvue de pistes conductives sur les deux côtés, et sont, après le durcissement des résistances, assemblées et pressées avec leurs faces internes portant les résistances tournées l'une vers l'autre, en intercalant une couche isolante.

2. Plaquette de circuit imprimé multicouche selon la revendication 1, caractérisée en ce que le pressage a lieu dans une presse ou en autoclave.

3. Plaquette de circuit imprimé multicouche selon l'une des revendications 1 ou 2, caractérisée en ce que les faces extérieures du circuit multicouche pressé sont garnies de composants SMD.

4. Plaquette de circuit imprimé multicouche selon la revendication 3 comprenant un sous-groupe de composants SMD avec des résistances ohmiques, caractérisée par la réalisation des résistances en tant que résistances imprimées par sérigraphie, obtenues en appliquant une pâte de résistance sur un matériau de base d'une plaquette de circuit imprimé au moyen d'un crible ou d'un gabarit, puis en la faisant durcir sous l'effet d'un apport de chaleur.

5. Plaquette de circuit imprimé multicouche selon la revendication 4, caractérisée par l'utilisation de pâtes de résistance polymères.

6. Plaquette de circuit imprimé multicouche selon la revendication 5, caractérisée en ce que les pâtes de résistance sont placées sur une base époxy ou phénolique.

7. Plaquette de circuit imprimé multicouche selon l'une des revendications 4 à 6, caractérisée en ce que les pâtes de résistance sont imprimées sur les plaquettes de circuit imprimé à l'aide d'une machine de sérigraphie.

8. Plaquette de circuit imprimé multicouche selon l'une des revendications 4 à 7, caractérisée par une configuration planiforme ou linéaire ou par un tracé plié des lignes correspondant à la valeur de la résistance/l'unité de superficie de la pâte de résistance.

9. Plaquette de circuit imprimé multicouche selon l'une des revendications 4 à 8, caractérisée par la disposition des résistances sous des composants ayant une grande surface.
